# EUROPÄISCHE PATENTANMELDUNG

(11) **EP 2 100 848 A1**
(43) Veröffentlichungstag der Anmeldung: **16.09.2009**
(21) Anmeldenummer: 08400007.4
(22) Anmeldetag: 11.03.2008
(51) Int. Cl.: B81B 3/00, G02B 26/08

(54) **Mikromechanisches Bauteil mit einem Spiegel und dessen Herstellungsverfahren**

(71) Anmelder: Fraunhofer-Gesellschaft zur Förderung der Angewandten Forschung e.V., 80686 München (DE); Technische Universität Chemnitz, 09111 Chemnitz (DE)
(72) Erfinder: Kurth, Steffen, Dr.-Ing., 09380 Thalheim (DE); Kaufmann, Christian, Dr.-Ing., 09217 Burgstädt (DE); Hahn, Ramon, Dipl.-Ing., 09126 Chemnitz (DE); Gessner, Thomas, Prof.Dr.-Ing.habil., 09113 Chemnitz (DE); Hiller, Karla, Dr.-Ing.habil., 08294 Lössnitz (DE)
(74) Vertreter: Steiniger, Carmen

(57) **Zusammenfassung**

Die vorliegende Erfindung betrifft ein mikromechanisches Bauteil, bei welchem flächig an einer Rückseite der Spiegelplatte wenigstens ein Spiegelversteifungs- und Koppelelement vorgesehen ist, das über die wenigstens eine Horizontalfeder mit dem Versteifungsrahmen gekoppelt ist, wobei die Horizontalfeder teilweise von der Spiegelplatte verdeckt ist. Die Aufgabe der Erfindung wird ferner durch ein Verfahren zum Herstellen eines mikromechanischen Bauteils zur Ablenkung elektromagnetischer Strahlung gelöst.

## Beschreibung

Die vorliegende Erfindung betrifft ein mikromechanisches Bauteil zur Ablenkung elektromagnetischer Strahlung mit einem Bauteilrahmen, einer in mehreren Achsen kippbaren Spiegelplatte, einem um die Spiegelplatte vorgesehenen und mit der Spiegelplatte über wenigstens eine Horizontalfeder und mit dem Bauteilrahmen über wenigstens eine Vertikalfeder gekoppelten Versteifungsrahmen; und elektrostatischen Kammelektroden oder wenigstens einem piezoelektrischen Antriebselement zur Ansteuerung von Kippbewegungen der Spiegelplatte. Die Erfindung betrifft ferner ein Verfahren zum Herstellen eines mikromechanischen Bauteils zur Ablenkung elektromagnetischer Strahlung.

Mikromechanische Bauteile der oben genannten Gattung werden insbesondere dazu verwendet, Licht, wie beispielsweise einen Laserstrahl, abzulenken und damit eine Bildwiedergabe zu realisieren. Hierzu sind im Stand der Technik verschiedene Wirkprinzipien bekannt.

In zahlreichen Anwendungsvarianten, wie beispielsweise in der Druckschrift EP 1526399 B1 oder der Druckschrift JP 2004139085 A, erfolgt eine Lichtablenkung durch die Kombination von Schwenkbewegungen, deren Schwenkachsen orthogonal zueinander orientiert sind. Die Einführung einer Bewegung bezüglich einer dritten Achse ist in der Druckschrift US 6924476 B2 beschrieben.

In den bekannten Konstruktionen besteht die Spiegelplatte meist aus Silizium und ist von zwei Torsionsfedern elastisch im Inneren eines Kardanringes gelagert, der wiederum von zwei weiteren Torsionsfedern elastisch an einem Chiprahmen befestigt ist. Die Torsionsfedern im Inneren des Kardanringes sind orthogonal zu denen angeordnet, die den Kardanring mit dem Chiprahmen verbinden, so dass beide Schwenkachsen ebenfalls orthogonal zueinander orientiert sind.

In den bekannten Anordnungen erfolgt der Antrieb der Spiegelschwenkbewegungen entweder, wie in den Druckschriften US 20040183149 A1 bzw. US 20050139678 A1 beschrieben, elektromagnetisch durch eine Spule auf dem Kardanring und durch außerhalb des Chips befestigte Dauermagnete oder, wie in der Druckschrift EP 1123526 B1 gezeigt, durch elektrostatische Kräfte, die mit kapazitiven Kammantrieben erzeugt werden. Die Kombination von elektrostatischer und elektromagnetischer Krafterzeugung ist beispielsweise in der Druckschrift US 7071594 B1 beschrieben.

Die Verwendung von Dauermagneten führt zu räumlich großen Bauteilen. Weiterhin bewirkt die Bestromung der Antriebsspule eine Erwärmung des Kardanringes durch die im elektrischen Widerstand der Spulenleiter umgesetzte Leistung. Das ist hinsichtlich des Einflusses auf die Parameter der mechanischen Anordnung und aus Gründen der Zuverlässigkeit nur bis zu einem bestimmten Grad tolerierbar.

Die Patentschriften US 6924476 B2 und US 6882462 B2 beschreiben eine mögliche Anordnung zur Kompensation der Linienverzerrung durch Einführung einer dritten Schwenkbewegung mit sehr kleiner Auslenkung, die durch eine asymmetrische Masseverteilung auf der Spiegelplatte erreicht wird. Der Schwenkwinkel dieser Bewegung ist jedoch immer an den Schwenkwinkel der schnellen Achse gebunden, da die Antriebsenergie aus der Bewegung der schnellen Achse entnommen wird. Eine Optimierung der Kompensation der Linienverzerrung ist deshalb nur begrenzt möglich.

Die Spiegelplatte unterliegt bei hohen Bewegungsfrequenzen Beschleunigungs- und Federkräften, die zu einer dynamischen Deformation der Spiegelplatte führen können. Das ist für die Lichtablenkung nur in Grenzen tolerierbar. Die Veröffentlichungsschrift DE 10 2005 033 800 A1 beschreibt eine Federanordnung, bei der die Federn im Inneren des Kardanringes so gestaltet sind, dass sie an mehreren Punkten an der Peripherie der Spiegelplatte angreifen und dadurch die angreifenden Kräfte verteilt werden. Weiterhin beschreibt die Patentschrift EP 1081528 B1 Versteifungsstrukturen auf der Rückseite der Spiegelplatte, die einer dynamischen Deformation der Spiegelplatte entgegenwirken, die Rotationsträgheit dadurch jedoch vergrößern, was unerwünscht ist.

Ein alternatives Verfahren zur Bilderzeugung besteht darin, zwei orthogonale Bewegungen eines Spiegels jeweils auf deren Resonanzfrequenz anzuregen, so dass beide Bewegungen etwa sinusförmig verlaufen. Dieses Prinzip ist beispielsweise in der Druckschrift WO 2003/032046 A1 beschrieben. Das Prinzip des Erzeugens von horizontal orientierten Zeilen, die durch eine gleichförmige Bewegung der langsamen Achse und eine schnelle Rückbewegung eine Bildfläche aufspannen, wird durch die Ausbildung einer Lissajous-Figur ersetzt. Dieses Verfahren hat den Vorteil, dass die Ansteuerspannungen, die dem Bauelement auferlegt werden müssen, verhältnismäßig klein sein können, da die Amplitudenverstärkung durch die Resonanz für beide Achsen nutzbar ist. Nachteilig ist jedoch, dass die Lissajous-Figuren unterschiedliche Linien- und Kreuzungsabstände im gesamten Bildfeld aufweisen und die erreichbare Auflösung durch die maximal auftretenden Abstände begrenzt wird.

In den letzten Jahren haben sich die Anforderungen an die Auflösung des Bildes, die durch die Anzahl der Zeilen je Bild und somit durch die Frequenz der sinusförmigen Bewegung, durch die Zeitspanne, die für den schnellen Rücklauf dem Bildaufbau entzogen wird und durch das Produkt aus Spiegeldurchmesser und maximalem Schwenkwinkel sowie durch die Spiegeldeformation bestimmt wird, erhöht. Hohe Auflösungen sind erreichbar durch kurze Rücklaufzeit, hohe Frequenz der schnellen Bewegung, großen Schwenkwinkel und große Spiegelplatte. Diese Anforderungen sind jedoch weitgehend konträr. Eine größere Spiegelplatte bewirkt ein entsprechend größeres Rotationsträgheitsmoment und führt zu niedrigerer Frequenz der sinusförmigen Bewegung der schnellen Scanachse sowie zu längerer Rücklaufzeit der langsamen Achse. Alternativ kann durch entsprechendes Dimensionieren der Steifigkeit der elastischen Aufhängungen eine höhere Frequenz bzw. ein kürzerer Rücklauf erreicht werden, wobei sich jedoch der maximal erreichbare Schwenkwinkel reduziert.

Es ist die Aufgabe der vorliegenden Erfindung, ein mikromechanisches Bauteil und ein zugehöriges Herstellungsverfahren zur Verfügung zu stellen, welche es ermöglichen, dass trotz großer Spiegelplatte eine hohe Frequenz der schnellen Achse, eine kurze Rücklaufzeit der Bewegung der langsamen Achse, eine geringe Spiegeldeformation und große maximal erreichbare Schwenkwinkel eingestellt werden können, wobei die im Stand der Technik bekannten Nachteile elektromagnetischer Antriebe möglichst nicht auftreten sollen.

Die Aufgabe wird einerseits durch ein mikromechanisches Bauteil der oben genannten Gattung gelöst, bei welchem flächig an einer Rückseite der Spiegelplatte wenigstens ein Spiegelversteifungs- und Koppelelement vorgesehen ist, das über die wenigstens eine Horizontalfeder mit dem Versteifungsrahmen gekoppelt ist, wobei die Horizontalfeder teilweise von der Spiegelplatte verdeckt ist.

Durch das Spiegelversteifungs- und Koppelelement wird zum einen die Spiegelplatte stabilisiert, so dass ungewollte Verbiegungen oder Verwölbungen der Spiegelplatte weitgehend minimiert werden können. Entsprechend tritt auch bei großen Spiegelplatten erfindungsgemäß nur eine geringe Spiegeldeformation auf, wobei große maximal erreichbare Schwenkwinkel eingestellt werden können. Ferner stellt das Spiegelversteifungs- und Koppelelement eine Kopplung der Spiegelplatte mit der Horizontalfeder zur Verfügung, über welche die Spiegelplatte mit hoher Frequenz in horizontaler Richtung geschwenkt werden kann. Dadurch, dass das Spiegelversteifungs- und Koppelelement derart an der Rückseite der Spiegelplatte vorgesehen ist, dass die Horizontalfeder so an dem Spiegelversteifungs- und Koppelelement angreifen kann, dass die Horizontalfeder teilweise von der Spiegelplatte verdeckt ist, wird eine Reduzierung der Rotationsträgheit bezüglich der langsamen Achse im Vergleich zu bisher bekannten Lösungen bewirkt, was zu einer schnelleren Umkehr der Ablenkrichtung führt. Somit kann trotz großer Spiegelplatte eine hohe Frequenz der schnellen Achse und eine kurze Rücklaufzeit der Bewegung der langsamen Achse eingestellt werden.

In einer vorteilhaften Ausführungsform der vorliegenden Erfindung ist zwischen dem wenigstens einen Spiegelversteifungs- und Koppelelement und der wenigstens einen Horizontalfeder wenigstens eine Kompensationsfeder vorgesehen, wobei die Kompensationsfeder so ausgebildet ist, dass eine Krafteinleitung von der wenigstens einen Horizontalfeder in die Spiegelplatte an wenigstens zwei verschiedenen Stellen des wenigstens einen Spiegelversteifungs- und Koppelelementes möglich ist. Die Kompensationsfeder ermöglicht eine zusätzliche Kippbewegung des Spiegels, deren Achse parallel zur langsamen Kippachse und parallel zur Vertikalfeder verläuft. Dadurch erfolgt eine wenigstens teilweise Kompensation der Linienverzerrung, deren Stärke durch die dafür eingesetzte Komponente der Antriebsspannung optimal eingestellt werden kann.

In einem bevorzugten Beispiel der vorliegenden Erfindung weist die Kompensationsfeder Federarme auf, die eine Gabel ausbilden und an einem der Horizontalfeder zugewandten Randbereich des Spiegelversteifungs- und Koppelelementes ansetzen. Hierdurch kann eine besonders vorteilhafte Krafteinleitung, ausgehend von der Horizontalfeder über die Kompensationsfeder, in die Spiegelplatte realisiert werden, wobei die Kompensationsfeder so unterhalb der Spiegelplatte angeordnet werden kann, dass diese nahezu vollständig von der Spiegelplatte verdeckt wird. Auf diese Weise kann die Spiegelplatte relativ groß dimensioniert werden und dennoch eine vorteilhafte Federwirkung einschließlich einer zumindest teilweisen Kompensation der Linienverzerrung hervorgerufen werden.

In einer weiteren Variante der vorliegenden Erfindung sind zwei Spiegelversteifungs- und Koppelelemente auf der Rückseite der Spiegelplatte ausgebildet, zwischen welchen die Kompensationsfeder derart angeordnet sind, dass jeder ihrer Federarme an einem der Spiegelversteifungs- und Koppelelemente ansetzt. Somit kann der Raum zwischen den Spiegelversteifungs- und Koppelelementen auf der Spiegelrückseite dafür genutzt werden, die Federarme der Kompensationsfeder unterzubringen. Mit dieser Konstruktion können auf günstige Weise die Spiegelversteifungs- und Koppeleigenschaften der Spiegelversteifungs- und Koppelelemente mit der Kompensationswirkung der Kompensationsfeder verbunden werden, ohne dass zusätzlicher Platz für diese Elemente verbraucht wird, so dass die Spiegelplatte groß dimensioniert werden kann.

Bei dieser Variante der Erfindung hat es sich als günstig erwiesen, wenn die Spiegelversteifungs- und Koppelelemente etwa U-förmig oder rechteckförmig ausgebildet sind. Die U- oder rechteckförmig ausgebildeten Spiegelversteifungs- und Koppelelemente können geeignet beispielsweise in Randnähe der Spiegelplatte angeordnet werden, während die Kompensationsfeder zwischen den Spiegelversteifungs- und Koppelelementen vorgesehen werden kann, wobei ihre Federarme jeweils an einem der Spiegelversteifungs- und Koppelelemente ansetzen. Durch die Ausbildung einer U-Form der Spiegelversteifungs- und Koppelelemente können besonders lange Federarme der Kompensationsfeder ausgebildet werden, wodurch eine sehr gute Kompensationswirkung hervorgerufen wird.

Es ist ganz besonders von Vorteil, wenn das wenigstens eine Spiegelversteifungs- und Koppelelement, die wenigstens eine Kompensationsfeder und ein überwiegender Teil der wenigstens einen Horizontalfeder von der Spiegelplatte verdeckt sind. Hierdurch kann im Wesentlichen der Platz, den die Spiegelplatte einnimmt, dafür genutzt werden, darunter das wenigstens eine Spiegelversteifungs- und Koppelelement, die wenigstens eine Kompensationsfeder und den überwiegenden Teil der wenigstens einen Horizontalfeder unterzubringen. Im Ergebnis kann eine große stabile Spiegelplatte ausgebildet werden und zusätzlich eine vorteilhafte Koppelwirkung zur Horizontalfeder realisiert werden, wobei durch die Horizontalfeder eine geeignete schnelle Spiegelansteuerung bewirkt wird und darüber hinaus durch die Kompensationsfeder Linienverzerrungseffekte verringert werden können.

In einer bevorzugten Ausführungsform der vorliegenden Erfindung ist die Spiegelplatte etwa in Form einer Ellipse ausgebildet, deren Hauptachse in Richtung der wenigstens einen Vertikalfeder liegt. Die Ellipsenform kann dabei auch derart gestreckt sein, dass ihre Seiten im Wesentlichen gerade und ihre Enden in Richtung der Hauptachse der Ellipse, bogenförmig ausgebildet sind. Hierdurch kann das Rotationsträgheitsmoment des Spiegels so optimiert werden, dass sich eine maximale Amplitudenverstärkung der sinusförmigen Schwingung auf dessen Resonanzfrequenz ergibt.

Gemäß einer weiteren vorteilhaften Ausbildung der vorliegenden Erfindung sind die elektrostatischen Kammelektroden aus Rotorelektroden und Statorelektroden ausgebildet, die eine Mehrzahl von Rotorzinken und Statorzinken ausweisen, wobei die freien Enden der Rotorzinken und der Statorzinken jeweils schmaler als deren feste Enden ausgebildet sind. Diese Ausführungsform bewirkt ein reduziertes Rotationsträgheitsmoment der Elektroden gegenüber bisher bekannten Lösungen.

Es hat sich ferner als vorteilhaft erwiesen, wenn die elektrostatischen Kammelektroden aus Rotorelektroden und Statorelektroden ausgebildet sind, die eine Mehrzahl von Rotorzinken und Statorzinken aufweisen, wobei die freien Enden der Rotorzinken eine von einer Geraden abweichende Berandungskurve aufweisen. Die spezielle Berandungskurve der Elektrodenkämme der Rotorelektroden abweichend von einer Geraden, gestattet eine Liniearisierung der Kennlinie im Bereich der mechanischen Ruheposition.

Günstig kann es auch sein, wenn das wenigstens eine Spiegelversteifungs- und Koppelelement so auf der Rückseite der Spiegelplatte ausgebildet ist, dass seine Ausdehnung in Richtung der wenigstens einen Vertikalfeder größer als seine Ausdehnung in Richtung der wenigstens einen Horizontalfeder ist. Hierdurch kann die Spiegelplatte beispielsweise in Form einer Ellipse ausgebildet werden, deren Hauptachse in Richtung der wenigstens einen Vertikalfeder liegt und der Platz unterhalb der Spiegelplatte kann vorteilhaft für die Ausbildung des wenigstens einen Spiegelversteifungs- und Koppelelementes genutzt werden, um eine besonders günstige Versteifungs- und Koppelwirkung zu erzielen.

Die Aufgabe der Erfindung wird ferner durch ein Verfahren zum Herstellen eines mikromechanischen Bauteils zur Ablenkung elektromagnetischer Strahlung, mit folgenden Schritten gelöst: Bereitstellen eines ersten Halbleitersubstrates, das wenigstens eine erste Halbleiterebene und eine zweite Halbleiterebene aufweist, die von einer Isolatorschicht voneinander getrennt sind, und eines zweiten Halbleitersubstrates; Strukturieren der ersten Halbleiterebene des ersten Halbleitersubstrates unter Ausbildung eines oberen Teils wenigstens eines Spiegelversteifungs- und Koppelelementes; Bonden der strukturierten Seite des ersten Halbleitersubstrates mit dem zweiten Halbleitersubstrat unter Ausbildung eines Substratverbundes; Strukturieren des zweiten Halbleitersubstrates von der Vorderseite des Substratverbundes unter Ausbildung einer Spiegelplatte, deren Rückseite mit dem oberen Teil des wenigstens einen Spiegelversteifungs- und Koppelelementes verbunden ist, eines oberen Teils eines um die Spiegelplatte angeordneten Versteifungsrahmens und eines oberen Teils von Statorelektroden; Strukturieren der ersten Halbleiterebene des ersten Halbleitersubstrates unter zumindest teilweiser Verwendung des zweiten Halbleitersubstrates als Maskierung und unter Ausbildung eines mittleren Teils des Versteifungsrahmens, wenigstens einer mit dem Versteifungsrahmen über ein Tragwerk gekoppelten Vertikalfeder, von Rotorelektroden und eines unteren Teils der Statorelektroden; und Strukturieren der zweiten Halbleiterebene des ersten Halbleitersubstrates von der Rückseite des Substratverbundes unter Ausbildung eines mit dem oberen Teils des Spiegelversteifungs- und Koppelelementes verbundenen unteren Teils des Spiegelversteifungs- und Koppelelementes, eines unteren Teils des Versteifungsrahmens und wenigstens einer mit dem wenigstens einen Spiegelversteifungs- und Koppelelement gekoppelten Horizontalfeder.

Durch das erfindungsgemäße Verfahren kann ein mikromechanisches Bauteil zur Ablenkung elektromagnetischer Strahlung mit einem Bauteilrahmen, einer in mehreren Achsen kippbaren Spiegelplatte, einem um die Spiegelplatte vorgesehenen und mit der Spiegelplatte über wenigstens eine Horizontalfeder und mit dem Bauteilrahmen über wenigstens eine Vertikalfeder gekoppelten Versteifungsrahmen, und elektrostatischen Kammelektroden zur Ansteuerung von Kippbewegungen der Spiegelplatte hergestellt werden, wobei flächig an einer Rückseite der Spiegelplatte wenigstens ein Spiegelversteifungs- und Koppelelement vorgesehen ist, das über die wenigstens eine Horizontalfeder mit dem Versteifungsrahmen gekoppelt ist, und wobei die Horizontalfeder erfindungsgemäß teilweise von der Spiegelplatte verdeckt ist. Hierdurch kann eine relativ große Spiegelplatte ausgebildet werden, da die Horizontalfeder im Wesentlichen unterhalb der Spiegelplatte angeordnet werden kann und damit nur ein minimaler zusätzlicher Platzbedarf für die Horizontalfeder vorgesehen werden muss. Zusätzlich wird durch das mit der Spiegelrückseite verbundene Spiegelversteifungs- und Koppelelement erreicht, dass die Spiegeldeformation gering ist und dennoch große maximal erreichbare Schwenkwinkel eingestellt werden können. Das mit dem erfindungsgemäßen Verfahren herstellbare mikromechanische Bauteil weist eine hohe Frequenz der schnellen Achse sowie eine kurze Rücklaufzeit der Bewegung der langsamen Achse auf. Ferner wird durch das Vorsehen von Stator- und Rotorelektroden erreicht, dass die im Stand der Technik bekannten Nachteile elektromagnetischer Antriebe bei dem erfindungsgemäß hergestellten mikromechanischen Bauteil nicht auftreten.

In einer bevorzugten Variante der vorliegenden Erfindung wird als erstes Halbleitersubstrat ein SOI-Wafer verwendet. Ein SOI-Wafer hat den Vorteil, dass er zwei Halbleiterebenen vereint, die durch eine Isolatorschicht voneinander getrennt sind, so dass durch einen Wafer sowohl die erste als auch die zweite Halbleiterebene des mikromechanischen Bauteils ausgebildet werden können.

In einem vorteilhaften Beispiel der Erfindung weist der SOI-Wafer einen die zweite Halbleiterebene ausbildenden Tragwafer mit einer Dicke von etwa 300 µm bis etwa 400 µm, eine die erste Halbleiterebene ausbildende Decklage mit einer Dicke von etwa 30 µm bis etwa 100 µm und eine Isolierschicht mir einer Dicke von etwa 300 nm bis etwa 3 µm auf. Die jeweiligen Dicken eignen sich besonders gut, um in den jeweiligen Halbleiterebenen insbesondere das wenigstens eine Spiegelversteifungs- und Koppelelement auszubilden und in den unterschiedlichen Halbleiterebenen bewegliche und starre Elemente des erfindungsgemäßen mikromechanischen Bauteils herzustellen.

Als zweites Halbleitersubstrat kann in bevorzugten Ausführungsformen der vorliegenden Erfindung ein Siliziumwafer oder ein SOI-Wafer verwendet werden. Derartige Wafer sind standardmäßig erhältlich und zeichnen sich durch die Verwendung von Silizium, durch ihre guten mechanischen Eigenschaften aus, so dass mechanische Bauteile mit sehr guten mechanischen Eigenschaften zur Verfügung gestellt werden können.

Beispielsweise weist das zweite Halbleitersubstrat eine Dicke von etwa 50 µm bis etwa 150 µm auf oder wird nach dem Bonden mit dem ersten Halbleitersubstrat auf eine Dicke von etwa 50 µm bis etwa 150 µm eingestellt. Diese Dicken sind besonders gut für die Ausbildung einer langzeitstabilen Spiegelplatte des erfindungsgemäßen mikromechanischen Bauteils geeignet.

In einer günstigen Weiterbildung der vorliegenden Erfindung wird bei der Strukturierung der zweiten Halbleiterebene des ersten Halbleitersubstrates wenigstens eine Kompensationsfeder zwischen der wenigstens einen Horizontalfeder und dem wenigstens einen Spiegelversteifungs- und Koppelelement ausgebildet. Mit Hilfe der Kompensationsfeder kann eine zusätzliche Kippbewegung des Spiegels, deren Achse parallel zur langsamen Kippachse und parallel zur Vertikalfeder verläuft, erzeugt werden. Hierdurch kann eine wenigstens teilweise Kompensation der Linienverzerrung der Spiegelstruktur erreicht werden.

Es hat sich als besonders günstig erwiesen, wenn bei der Strukturierung des zweiten Halbleitersubstrates zunächst senkrechte Vertiefungen in das zweite Halbleitersubstrat eingebracht werden, deren Boden etwa in der Hälfte der Dicke des zweiten Halbleitersubstrates liegt, und daraufhin die verbliebenen Halbleiterbereiche und mit einem Isolator abgedeckte Bereiche des zweiten Halbleitersubstrates als Maskierung für eine weitere Strukturierung des zweiten Halbleitersubstrates verwendet werden. Durch diese Vorgehensweise können Elemente des mikromechanischen Bauteils mit unterschiedlicher Dicke in dem selben, zweiten Halbleitersubstrat ausgebildet werden.

Dies kann man dadurch erreichen, dass das zweite Halbleitersubstrat mit Hilfe eines zweistufigen fotolithographischen Prozesses strukturiert wird. Somit können zunächst in das zweite Halbleitersubstrat, beispielsweise mittels reaktivem Ionenätzen (RIE), senkrechte Vertiefungen eingebracht werden, deren Endpunkt etwa in der Hälfte des zweiten Halbleitersubstrates liegt. Nach Entfernen der zweiten Fotolackschicht können wiederum mittels reaktivem Ionenätzen alle nun freiliegenden Bereiche des zweiten Halbleitersubstrates und anschließend alle nicht durch das Halbleitermaterial geschützten Gebiete geätzt werden.

In einer bevorzugten Variante der vorliegenden Erfindung wird die Spiegelplatte nach der Strukturierung des ersten und des zweiten Halbleitersubstrates mit einer Reflexionsschicht beschichtet. Zu diesem Zeitpunkt sind die wesentlichen Strukturierungsprozesse zur Herstellung des mikromechanischen Bauteils bereits abgeschlossen, so dass die Reflexionsschicht im Wesentlichen keinen weiteren Beeinträchtigungen durch Halbleiterstrukturierungsprozesse unterliegt. Somit kann eine Reflexionsschicht mit besonders guten optischen Eigenschaften auf der Spiegelplatte erzeugt werden.

In diesem Zusammenhang hat es sich als günstig erwiesen, wenn die Beschichtung der Spiegelplatte über eine Hartmaske erfolgt. Auf diese Weise kann speziell die Spiegelplatte beschichtet werden, ohne dass auf die übrigen Bereiche der mikromechanischen Bauteilstruktur Schutzschichten aufgebracht werden müssen.

Es ist jedoch gemäß einer weiteren Ausführungsform der vorliegenden Erfindung auch möglich, dass die Spiegelplatte vor einem ersten Trockenätzschritt zur Strukturierung des Substratverbundes mit einer Reflexionschicht beschichtet wird. Auf diese Weise kann die Reflexionsschicht schon zu Beginn der Technologie auf die Spiegelplatte aufgebracht werden, wobei eine Beschichtung der Spiegelplatte noch relativ einfach unter Verwendung fotolithographischer Techniken möglich ist.

Es ist besonders von Vorteil, wenn Bereiche der ersten Halbleiterebene des ersten Halbleitersubstrates und Bereiche des zweiten Halbleitersubstrates mit elektrisch leitfähigen Bondpads versehen werden. Somit kann das durch das erfindungsgemäße Verfahren hergestellte mikromechanische Bauteil auf einfache Weise über die Bondpads elektrisch kontaktiert werden.

In einer weiteren günstigen Weiterbildung der vorliegenden Erfindung erfolgt die Beschichtung der Spiegelplatte und die Ausbildung der Bondpads über eine gemeinsame Hartmaske. Somit können die Beschichtung der Spiegelplatte und die Ausbildung der Bondpads in einem technologischen Schritt realisiert werden.

Es ist darüber hinaus von Vorteil, wenn Vorder- und Rückseite des strukturierten Substratverbundes mit jeweils einer Abdeckung versehen werden. Durch die Abdeckung kann der strukturierte Substratverbund vor Umwelteinflüssen geschützt werden, so dass eine dauerhafte Funktion und Qualität des mit dem erfindungsgemäßen Verfahren hergestellten mikromechanischen Bauteils zur Verfügung gestellt werden kann.

Hierbei ist es besonders günstig, wenn die Vorderseite des Substratverbundes mit einer zumindest teilweise optisch transparenten Abdeckung versehen wird. Durch die Lichtdurchlässigkeit der Abdeckung auf der Vorderseite des Substratverbundes wird es ermöglicht, dass Licht auf die Spiegelplatte des mikromechanischen Bauteils auftreffen kann und von diesem abgelenkt werden kann.

Vorteilhafte Ausführungsformen der vorliegenden Erfindung, deren Funktionen und Vorteile, werden im Folgenden anhand der Figuren der Zeichnung näher erläutert, wobei
- Figur 1: schematisch eine Draufsicht auf eine Ausführungsform eines mikromechanischen Bauteils gemäß der vorliegenden Erfindung zeigt;
- Figur 2: schematisch eine mögliche Anordnungsvariante von zwei Spiegelversteifungs- und Koppelelementen auf der Rückseite einer Spiegelplatte eines mikromechanischen Bauteils gemäß der vorliegenden Erfindung zeigt;
- Figur 3: schematisch eine weitere mögliche Ausführungsvariante der Anordnung von zwei Spiegelversteifungs- und Koppelelementen auf der Rückseite einer Spiegelplatte eines mikromechanischen Bauteils gemäß der vorliegenden Erfindung zeigt;
- Figur 4: schematisch eine mögliche Anordnung von Rotorelektroden und Statorelektroden eines mikromechanischen Bauteils gemäß der vorliegenden Erfindung zeigt, wobei die freien Enden der Rotorzinken eine von einer Geraden abweichende Berandungskurve aufweisen;
- Figur 5: schematisch eine mögliche Ausführungsform von Rotorelektroden und Statorelektroden eines mikromechanischen Bauteils gemäß der vorliegenden Erfindung zeigt, wobei die freien Enden der Rotorzinken und der Statorzinken jeweils schmaler als deren feste Enden ausgebildet sind,
- Figur 6: schematisch einen möglichen Aufbau eines ersten Halbleitersubstrates für eine Verwendung in dem erfindungsgemäßen Verfahren zum Herstellen eines mikromechanischen Bauteils zeigt;
- Figur 7: schematisch das Halbleitersubstrat aus Fig. 6 nach einer ersten Strukturierung einer ersten Halbleiterebene des Halbleitersubstrates gemäß dem erfindungsgemäßen Verfahren zum Herstellen eines mikromechanischen Bauteils zeigt;
- Figur 8: schematisch das strukturierte Halbleitersubstrat aus Fig. 7 nach einem Bondschritt mit einem zweiten Halbleitersubstrat gemäß dem erfindungsgemäßen Verfahren zum Herstellen eines mikromechanischen Bauteils zeigt;
- Figur 9: schematisch den Substratverbund aus Fig. 8 nach einer ersten Strukturierung des zweiten Halbleitersubstrates gemäß dem erfindungsgemäßen Verfahren zum Herstellen eines mikromechanischen Bauteils zeigt;
- Figur 10: schematisch eine weitere Strukturierung der ersten Halbleiterebene des ersten Halbleitersubstrates der Struktur aus Fig. 9 gemäß dem erfindungsgemäßen Verfahren zum Herstellen eines mikromechanischen Bauteils zeigt, wobei das strukturierte zweite Halbleitersubstrat zumindest teilweise als Maskierung zur Strukturierung der ersten Halbleiterebene verwendet wird;
- Figur 11: schematisch die Struktur aus Fig. 10 nach einer weiteren Strukturierung der ersten Halbleiterebene des ersten Halbleitersubstrates unter Verwendung des zweiten Halbleitersubstrates als Maskierung gemäß dem erfindungsgemäßen Verfahren zum Herstellen eines mikromechanischen Bauteils zeigt;
- Figur 12: schematisch die Struktur aus Fig. 11 nach einer Strukturierung der zweiten Halbleiterebene des ersten Halbleitersubstrates von der Rückseite des Substratverbundes gemäß dem erfindungsgemäßen Verfahren zum Herstellen eines mikromechanischen Bauteils zeigt;
- Figur 13: schematisch die Struktur aus Fig. 12 nach einer Entfernung von Isolatorschichten und einem Abscheiden einer Reflexionsschicht auf der Spiegelplatte gemäß dem erfindungsgemäßen Verfahren zum Herstellen eines mikromechanischen Bauteils zeigt;
- Figur 14: schematisch eine spezielle Ausführungsform des erfindungsgemäßen mikromechanischen Bauteils mit auf der Vorder- und Rückseite vorgesehenen Abdeckungen zeigt; und

- Figur 15: schematisch eine weitere Ausführungsvariante des erfindungsgemäßen mikromechanischen Bauteils mit einem piezoelektrischen Antrieb zeigt.

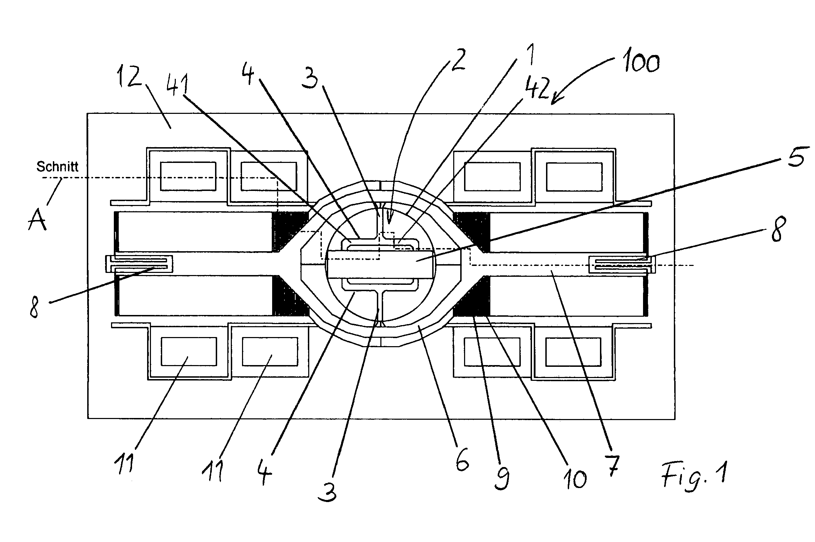

Fig. 1 zeigt schematisch ein mikromechanisches Bauteil 100 zur Ablenkung elektromagnetischer Strahlung, wie beispielsweise von Laserstrahlung, in der Draufsicht, wobei verdeckte Ebenen, insbesondere unterhalb der Spiegelplatte 1, dargestellt sind.

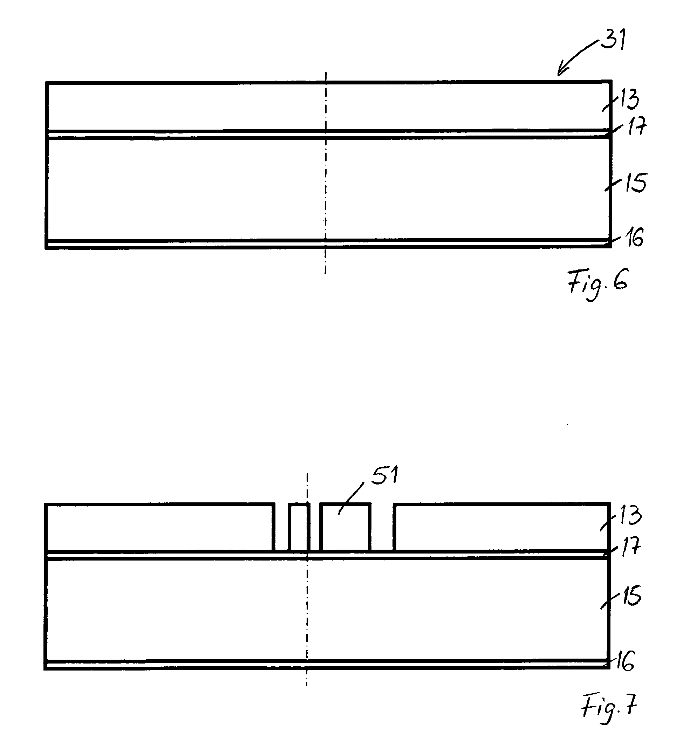

Die mit dem Bezugszeichen A gekennzeichnete Strichpunktlinie gibt die Schnittrichtung der in den Fig. 6 bis 14 dargestellten schematischen Schnittdarstellungen des mikromechanischen Bauteils 100 wieder.

Das mikromechanische Bauteil 100 weist einen feststehenden Bauteil- oder Chiprahmen 12 auf, mit welchem im Wesentlichen alle übrigen Komponenten des mikromechanischen Bauteils 100 elastisch oder starr verbunden sind.

Das mikromechanische Bauteil 100 weist zur Lichtablenkung eine kippbare Spiegelplatte 1 auf. Auf der Spiegelplatte 1 ist eine Reflexionsschicht 22 vorgesehen, welche beispielsweise aus Aluminium besteht. In anderen Ausführungsformen der Erfindung kann die Reflexionsschicht auch aus anderen reflektierenden Materialien, wie beispielsweise Silber oder Gold, bestehen.

In dem in Fig. 1 gezeigten Beispiel ist die Spiegelplatte 1 über zwei Kompensationsfedern 4, zwei Horizontalfedern 3 und zwei Vertikalfedern 8 elastisch mit dem Bauteilrahmen 12 verbunden. Grundsätzlich ist es jedoch ausreichend, wenn die Spiegelplatte 1 durch wenigstens eine Horizontalfeder 3 und wenigstens eine Vertikalfeder 8 mit dem Chiprahmen 12 elastisch verbunden ist.

Durch die wenigstens eine Horizontalfeder 3 kann derart eine Kraft in die Spiegelplatte 1 eingeleitet werden, dass diese horizontal mit einer hohen Frequenz schwenkbar ist. Durch die wenigstens eine Vertikalfeder 8 wird erreicht, dass eine Kraft derart in die Spiegelplatte 1 eingeleitet werden kann, so dass diese langsam in vertikaler Richtung schwenkbar ist. Die wenigstens eine Horizontalfeder 3 und die wenigstens eine Vertikalfeder 8 sind hierzu orthogonal zueinander ausgerichtet. Durch die Schwenkbarkeit der Spiegelplatte 1 in horizontaler und vertikaler Richtung mit unterschiedlicher Geschwindigkeit kann durch die Spiegelplatte 1 eine elektromagnetische Strahlung so abgelenkt werden, dass viele horizontale Zeilen innerhalb eines Feldes beschrieben werden können und damit ein Bild aufgespannt wird.

Gemäß dem in Fig. 1 aufgezeigten Ausführungsbeispiel des mikromechanischen Bauteils 100 sind die Horizontalfedern 3 jeweils über Kompensationsfedern 4 mit der Spiegelplatte 1 verbunden. Die Kompensationsfedern 4 sind in dem gezeigten Ausführungsbeispiel etwa gabelförmig ausgebildet, wobei die Federarme 41, 42, die die Gabel ausbilden, jeweils an einem der Horizontalfeder 3 zugewandten Randbereich eines an einer Rückseite 112 der Spiegelplatte 1 vorgesehenen Spiegelversteifungs- und Koppelelementes 5 ansetzen.

Somit sind in dem erfindungsgemäßen mikromechanischen Bauteil 100 die Federn 3, 4 und 8 nicht direkt sondern indirekt, über das wenigstens eine Spiegelversteifungs- und Koppelelement 5 mit der Spiegelplatte 1 verbunden.

Mit Hilfe des Spiegelversteifungs- und Koppelelementes 5, das in einer Halbleiterebene unter der Ebene der Spiegelplatte 1 an diese ansetzt, wird die Spiegelplatte 1 von deren Rückseite 112 her versteift, was einer dynamischen Deformation der Spiegelplatte 1 entgegenwirkt. Ferner wird durch das Spiegelversteifungs- und Koppelelement 5 eine Kopplung zwischen der Spiegelplatte 1 und den Horizontalfedern 3 bzw. Kompensationsfedern 4 ausgebildet.

In Fig. 1 ist die Spiegelplatte 1 relativ zu den Horizontalfedern 3 so angeordnet, dass die Drehachse der schnellen Scanbewegung nicht in der Ebene der Spiegelplatte 1 liegt, die Drehachse der langsamen Bewegung jedoch in der Ebene der Vertikalfedern 8 liegt.

In dem in Fig. 1 gezeigten Beispiel ist die Spiegelplatte 1 im Wesentlichen rund ausgebildet. Sie kann jedoch in anderen Ausführungsformen der vorliegenden Erfindung auch elliptisch oder in Form einer gestreckten Ellipse, beispielsweise mit zueinander parallelen, geraden Seitenbereichen ausgebildet sein. Bei solchen Ausführungsvarianten ist es von Vorteil, wenn die Spiegelplatte 1 so innerhalb des mikromechanischen Bauteils 100 ausgerichtet ist, dass ihre längere bzw. ihre Hauptachse in Richtung der wenigstens einen Vertikalfeder 8 liegt.

In dem Ausführungsbeispiel aus Fig. 1 ist an der Rückseite 112 der Spiegelplatte 1 nur ein Spiegelversteifungs- und Koppelelement 5 vorgesehen. Es ist jedoch auch möglich, dass mehrere Spiegelversteifungs- und Koppelelemente 5a, 5b auf der Spiegelrückseite 112 vorgesehen werden können. In dem in Fig. 1 gezeigten Beispiel ist das eine Spiegelversteifungs- und Koppelelement 5 etwa rechteckförmig mit seiner Längsausdehnung in Ausrichtung der Vertikalfedern 8 auf der Spiegelrückseite 112 vorgesehen. Dabei verdeckt die Spiegelplatte 1 in der Draufsicht das Spiegelversteifungs- und Koppelelement 5 und die daran ansetzenden Federarme 41, 42 der Kompensationsfedern 4 sowie teilweise die Horizontalfedern 3.

In dem mikromechanischen Bauteil 100 aus Fig. 1 ist der überwiegende Teil der beiden Horizontalfedern 3 von der Spiegelplatte 1 verdeckt. Somit kann die Spiegelplatte 1 relativ groß ausgebildet werden und dadurch eine hohe Frequenz der schnellen Achse in horizontaler Richtung erzielt werden. Da die Horizontalfedern 3 und die Kompensationsfedern 4 nahezu vollständig durch die Spiegelplatte 1 verdeckt sind, wird eine Reduzierung der Rotationsträgheit bezüglich der langsamen Achse des Spiegels im Vergleich zu bisher bekannten Lösungen bewirkt, was zu einer schnelleren Umkehr in Ablenkrichtung führt.

Die Dicke der Spiegelplatte 1, des wenigstens einen Spiegelversteifungs- und Koppelelementes 5 und der Horizontalfedern 3 sowie der Vertikalfedern 8 sind durch den Schichtaufbau des mikromechanischen Bauteils 100 unabhängig voneinander dimensionierbar. Entsprechend erlaubt die Schichtdickenwahl eine unabhängige Dimensionierung der Spiegeldicke, der Dicke der Horizontalfedern 3 und der Vertikalfedern 8 sowie der in Fig. 1 für die Ansteuerung der Spiegelplatte 1 verwendeten elektrostatischen Kammelektroden 9, 10.

Die Horizontalfedern 3 sind einerseits mit den Kompensationsfedern 4 und andererseits mit einem um die Spiegelplatte 1 angeordneten Versteifungsrahmen 6 elastisch verbunden. Der Versteifungsrahmen 6 ist in dem Ausführungsbeispiel von Fig. 1 in Form eines Kardan- bzw. Gimbal-Ringes ausgebildet. An den Versteifungsrahmen 6 setzt ein Tragwerk 7 an, an welchem wiederum die Vertikalfedern 8 ansetzen.

Die Ansteuerung der Spiegelplatte 1 erfolgt in der Ausführungsvariante von Fig. 1 mittels elektrostatischer Kammelektroden 9, 10, die aus Rotorelektroden 9 und Statorelektroden 10 ausgebildet sind und eine Mehrzahl von Rotorzinken 25 und Statorzinken 26 aufweisen. In anderen Ausführungsvarianten der vorliegenden Erfindung kann die Ansteuerung der Spiegelplatte 1 auch über wenigstens ein piezoelektrisches Antriebselement 24 realisiert werden. Das wenigstens eine piezoelektrische Antriebselement 24 kann beispielsweise an einem Tragwerk 7 zwischen den Vertikalfedern 8 und dem Versteifungsrahmen 6 vorgesehen werden. Durch die elektrostatischen Kammantriebe oder das wenigstens eine piezoelektrische Antriebselement kann die Kraft am Versteifungsrahmen 6 eingeleitet werden und eine langsame Kippachse parallel zur Vertikalfeder 8 und eine schnelle Kippachse parallel zur Horizontalfeder 3 angetrieben werden.

Somit kann die Bewegung um eine Schwenkachse der Spiegelplatte 1 durch Anlegen von elektrischen Spannungen so erfolgen, dass die Bewegung der Spiegelplatte 1 der Spannung bis zu einer maximalen Frequenz zeitgleich erfolgt. Die Bewegung um eine zweite, zur ersten Achse orthogonalen Schwenkachse, erfolgt bei Anlegen einer zweiten elektrischen Spannung bauartbedingt sinusförmig mit einer viel höheren Frequenz als die erstgenannte Bewegung. Dadurch kann beispielsweise ein einfallender Laserstrahl so abgelenkt werden, dass er durch die höherfrequente sinusförmige Bewegung viele horizontale Zeilen innerhalb eines Feldes beschreibt, das durch die erstgenannte Schwenkbewegung aufgespannt wird. Optional kann durch die Kompensationsfedern 4 eine dritte Bewegung um eine bauartsbedingte Schwenkachse, die zur erstgenannten Schwenkachse parallel angeordnet ist, mit einer weiterhin höheren Frequenz sinusförmig durch Anlegen von entsprechenden elektrischen Spannungen erzeugt werden.

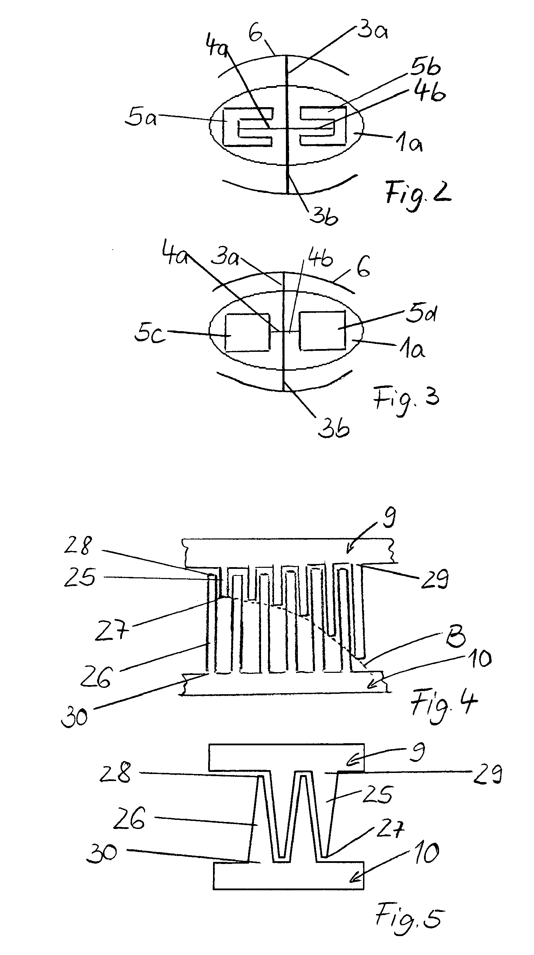

Fig. 2 zeigt schematisch einen Ausschnitt des erfindungsgemäßen mikromechanischen Bauteils in einer Draufsicht auf dessen Rückseite, wobei auf einer Spiegelrückseite 112 einer Spiegelplatte 1a etwa U-förmige Spiegelversteifungs- und Koppelelemente 5a, 5b vorgesehen sind. Zwischen den Spiegelversteifungs- und Koppelelementen 5a, 5b ist eine Kompensationsfeder 4 aufgespannt, deren Federarme 4a, 4b jeweils an den Spiegelversteifungs- und Koppelelementen 5a, 5b ansetzen. Die Kompensationsfeder 4 ist mit einer Horizontalfeder 3 gekoppelt, deren Federarme 3a, 3b wiederum elastisch mit einem Versteifungsrahmen 6 gekoppelt sind.

Fig. 3 zeigt schematisch eine weitere mögliche Ausführungsvariante der Anordnung von zwei Spiegelversteifungs- und Koppelelementen 5c, 5d auf der Rückseite 112 einer Spiegelplatte 1 a eines erfindungsgemäßen mikromechanischen Bauteils 100. Auch hier ist eine Kompensationsfeder 4 zwischen den beiden Spiegelversteifungs- und Koppelelementen 5c, 5d vorgesehen, deren Federarme 4a, 4b an jeweils einem der Spiegelversteifungs- und Koppelelemente 5c, 5d angreifen. Die Kompensationsfeder 4 ist, wie in der Ausführungsform von Fig. 2, über eine Horizontalfeder 3 mit dem Versteifungsrahmen 6 elastisch gekoppelt.

Fig. 4 zeigt schematisch eine Draufsicht auf eine Ausführungsvariante von elektrostatischen Kammelektroden 9, 10, welche bei dem mikromechanischen Bauteil 100 aus Fig. 1 Verwendung finden können. In der speziellen Ausführungsvariante von Fig. 4 weisen die Rotorelektroden 9 eine Mehrzahl von Rotorzinken 25 auf, deren freie Enden 27 eine von einer Geraden abweichende Berandungskurve B aufweisen. Diese gestattet eine Linearisierung der Kennlinie im Bereich der mechanischen Ruheposition.

Fig. 5 zeigt schematisch ein Ausführungsbeispiel für elektrostatische Kammelektroden 9, 10, die eine Mehrzahl von Rotorzinken 25 und Statorzinken 26 aufweisen, wobei die freien Enden 27, 28 der Rotorzinken 25 und der Statorzinken 26 jeweils schmaler als deren feste Enden 29, 30 ausgebildet sind. Diese Ausbildung bewirkt ein reduziertes Rotationsträgheitsmoment der Elektroden 9, 10 gegenüber bisherigen Lösungen.

Im Folgenden wird anhand der Fig. 6 bis 14 eine vorteilhafte Ausführungsvariante des erfindungsgemäßen Verfahrens zum Herstellen eines mikromechanischen Bauteils, wie des mikromechanischen Bauteils 100 aus Fig. 1, zur Ablenkung elektromagnetischer Strahlung beschrieben.

Fig. 6 zeigt schematisch in einer Seitenansicht ein erstes Halleitersubstrat 31 mit einer ersten Halbleiterebene 13 und einer zweiten Halbleiterebene 15, die von einer Isolatorschicht 17 voneinander getrennt sind. Das erste Halbleitersubstrat 31 ist in dem gezeigten Beispiel ein SOI-Wafer. Der gezeigte SOI-Wafer weist einen die zweite Halbleiterebene 15 ausbildenden Tragwafer mit einer Dicke von etwa 300 µm bis etwa 400 µm, eine die erste Halbleiterebene 13 ausbildende Decklage mit einer Dicke von etwa 30 µm bis etwa 100 µm und eine Isolatorschicht 17 mit einer Dicke von etwa 300 nm bis etwa 3 µm auf.

In anderen Ausführungsvarianten der Erfindung können anstelle des SOI-Wafers auch miteinander gebondete einzelne Wafer verwendet werden, wobei sich die Dickenwerte der einzelnen Ebenen auch von dem in Fig. 6 gezeigten SOI-Wafer unterscheiden können. Beispielhaft kann hier ein SOI-Wafer bestehend aus einem 350 µm dicken Tragwafer 15 und einer 50 µm dicken Deckschicht 13 genutzt werden.

Die Rückseite des SOI-Wafers ist mit einer Isolatorschicht 16 bedeckt, die beispielsweise aus 2 µm dickem Siliziumdioxid besteht.

Fig. 7 zeigt schematisch das erste Halbleitersubstrat 31 aus Fig. 6 nach einer ersten Strukturierung in der ersten Halbleiterebene 13. Die Strukturierung erfolgt mit Hilfe einer Lackschicht, über welche die erste Halbleiterebene 13 vorzugsweise durch reaktives Ionenätzen (RIE) strukturiert wird. Im Ergebnis dieser Stufe des erfindungsgemäßen Verfahrens entsteht ein oberer Teil 51 wenigstens eines Spiegelversteifungs- und Koppelelementes 5 des erfindungsgemäßen mikromechanischen Bauteils 100.

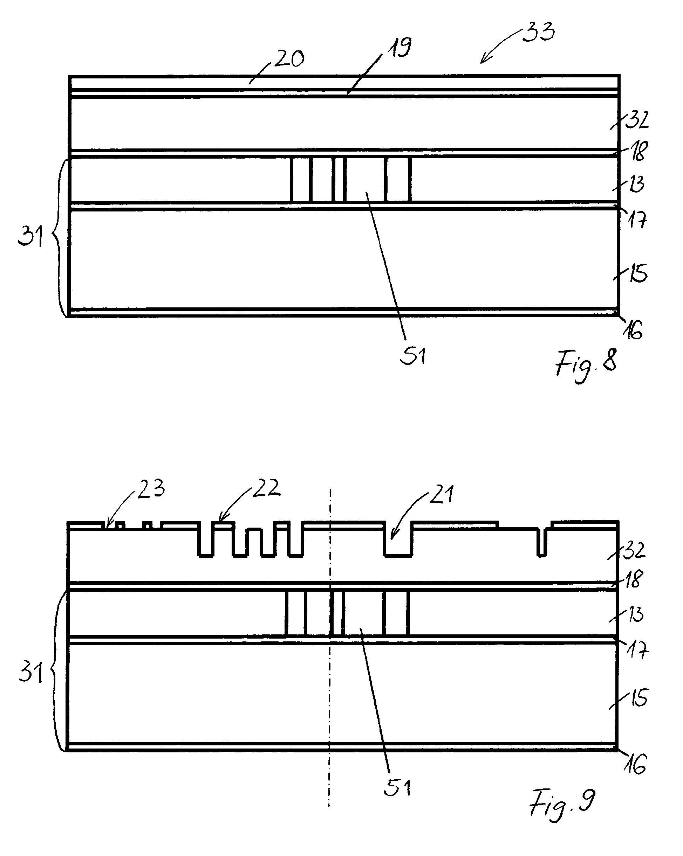

Fig. 8 zeigt schematisch das strukturierte erste Halbleitersubstrat 31 aus Fig. 7 nach einem Bondschritt mit einem zweiten Halbleitersubstrat 32. In dem gezeigten Beispiel wird als zweites Halbleitersubstrat 32 ein Siliziumwafer verwendet. In anderen Ausführungsvarianten der vorliegenden Erfindung kann als zweites Halbleitersubstrat 32 beispielsweise auch ein SOI-Wafer eingesetzt werden. Vorzugsweise werden das erste Halbleitersubstrat 31 und das zweite Halbleitersubstrat 32 mittels Silizium-Direkt-Bonden miteinander verbunden.

Die Dicke des in dem in Fig. 8 gezeigten Beispiel für das zweite Halbleitersubstrat verwendeten Siliziumwafers kann 30 µm bis 150 µm betragen und liegt vorzugsweise bei etwa 80 µm. Vor dem Bonden der beiden Halbleitersubstrate 31, 32 wird das zweite Halbleitersubstrat 32 beidseitig mit einer Oxidschicht 18, 19 versehen. Die Dicke dieser Oxidschichten 18, 19 beträgt im gezeigten Ausführungsbeispiel ca. 1 µm. Anschließend wird die Oberseite des aus den Halbleitersubstraten 31, 32 hergestellten Substratverbundes 33 mit einer weiteren Oxidschicht 20 versehen, welche in dem gezeigten Ausführungsbeispiel eine 1,5 µm dicke PE-CVD-SiO₂-Schicht ist.

Abweichend von dieser Verfahrensweise kann ein Siliziumwafer beliebiger Dicke durch Silizium-Direkt-Bonden mit dem SOI-Wafer 31 verbunden werden. Die gewünschte Enddicke des Siliziumwafers kann anschließend durch Läppen, Polieren und/oder Siliziumätzen eingestellt werden. Danach kann der Substratverbund thermisch oxidiert werden und die Oberseite mit einer weiteren Oxidschicht 20 versehen werden.

Fig. 9 zeigt schematisch den Substratverbund 33 aus Fig. 8 nach einer ersten Strukturierung des zweiten Halbleitersubstrates 32 von der Vorderseite des Substratverbundes 33. Hierfür wurden in das zweite Halbleitersubstrat 32 bzw. den in der speziellen Ausführungsvariante von Fig. 9 verwendeten Siliziumwafer mit Hilfe eines speziellen zweistufigen fotolithographischen Prozesses mittels RIE senkrechte Vertiefungen 21 eingebracht, deren Endpunkt bzw. Boden etwa in der Hälfte der Dicke des zweiten Halbleitersubstrates 32 liegt. Wie in Fig. 9 gezeigt, weist die Oberfläche des zweiten Halbleitersubstrates 32 im Ergebnis dieses Ätzschrittes Gebiete mit Vertiefungen 21, mit Oxid bedeckte Gebiete 22 und Gebiete 23 mit freiem Halbleitermaterial bzw. Silizium auf.

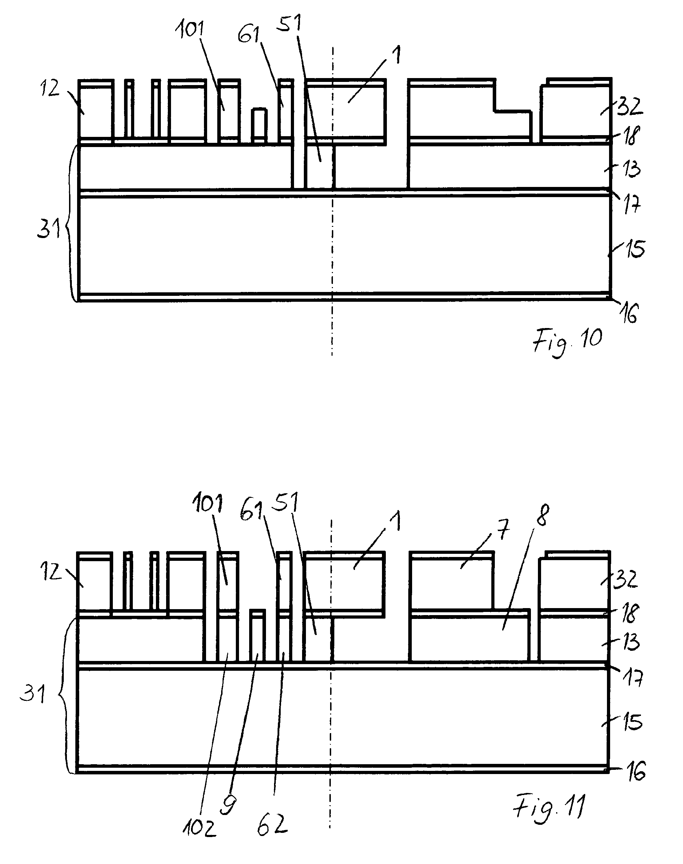

Fig. 10 zeigt schematisch den strukturierten Substratverbund 33 nach einer weiteren Strukturierung des zweiten Halbleitersubstrates 32. Um zu dieser Struktur zu gelangen, werden nach Entfernen einer zweiten Fotolackschicht wiederum mittels des RIE alle nun freiliegenden Halbleitergebiete 23 des zweiten Halbleitersubstrates 32 und alle nicht durch Halbleitermaterial geschützten Gebiete 18 geätzt. Im Ergebnis dieses Verfahrensschrittes entstehen in der Ebene des zweiten Halbleitersubstrates 32 die Spiegelplatte 1, deren Rückseite 112 mit dem oberen Teil 51 des wenigstens einen Spiegelversteifungs- und Koppelelementes 5 verbunden ist, ein oberer Teil 61 eines um die Spiegelplatte 1 angeordneten Versteifungsrahmens 6 und ein oberer Teil 101 von Statorelektroden 10.

Fig. 11 zeigt schematisch die Struktur aus Fig. 10 nach einem weiteren Verfahrensschritt, in welchem die erste Halbleiterebene 13 des ersten Halbleitersubstrates 31 unter zumindest teilweiser Verwendung des strukturierten zweiten Halbleitersubstrates 32 als Maskierung in einem weiteren RIE-Prozess strukturiert wird. Im Ergebnis dieses Prozesses entstehen ein mittlerer Teil 62 des Versteifungsrahmens bzw. Kardanringes 6, wenigstens eine mit dem Versteifungsrahmen 6 über ein Tragwerk 7 gekoppelte Vertikalfeder, Rotorelektroden 9 und ein unterer Teil 102 der Statorelektroden 10 in der ersten Halbleiterebene 13 des ersten Halbleitersubstrates 31 des Substratverbundes.

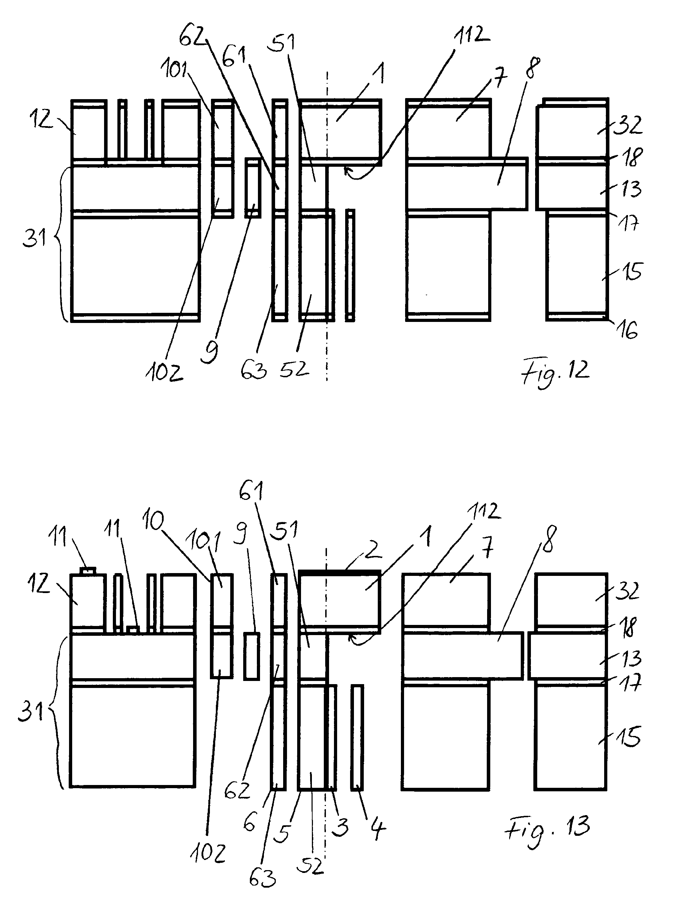

Fig. 12 zeigt schematisch den Schichtaufbau aus Fig. 11 nach einer Strukturierung der zweiten Halbleiterebene 15 des ersten Halbleitersubstrates 31. Hierzu wird die Oxidschicht 16 auf der Rückseite des Substratverbundes mit Hilfe einer Fotolackschicht strukturiert und anschließend das nicht geschützte Halbleitermaterial der zweiten Halbleiterebene 15 von der Rückseite des Substratverbundes mittels RIE entfernt. Dabei werden ein mit dem oberen Teil 51 des Spiegelversteifungs- und Koppelelementes 5 verbundener unterer Teil 52 des Spiegelversteifungs- und Koppelelementes 5, ein unterer Teil 63 des Versteifungsrahmens bzw. Kardanringes 6 und wenigstens eine mit dem wenigstens einen Spiegelversteifungs- und Koppelelement 5 gekoppelte Horizontalfeder 3 ausgebildet.

Fig. 13 zeigt schematisch die Struktur aus Fig. 12 nach einer Entfernung der Isolatorschichten 16 und 17 sowie einer Abscheidung einer Reflexionsschicht 2 auf der Spiegelplatte 1. Die Isolatorschichten 16 und 17 werden vorzugsweise mit Hilfe eines RIE-Prozesses entfernt. Als Reflexionsschicht 2 wird vorzugsweise eine metallische Schicht, wie beispielsweise Aluminium, auf die Spiegelplatte 1 abgeschieden. Als Refelextionsschicht 2 kann jedoch auch ein anderes Material oder auch eine Schichtfolge, wie beispielsweise Silber, Gold oder ein Schichtstapel aus Metall und/oder einem dielektrischen Schichtsystem, verwendet werden.

In dem in Fig. 13 gezeigten Ausführungsbeispiel des erfindungsgemäßen Verfahrens erfolgt die Abscheidung der Reflexionsschicht 2 durch Sputtern über eine Hartmaske. Dabei kann gleichzeitig mit der Beschichtung der Spiegelplatte 1 eine Ausbildung elektrisch leitfähiger Bondpads 11 auf Bereichen der ersten Halbleiterebene 13 des ersten Halbleitersubstrates 31 und Bereichen des zweiten Halbleitersubstrates 32 erfolgen, wobei die Beschichtung der Spiegelplatte 1 und die Ausbildung der Bondpads 11 über eine gemeinsame Hartmaske erfolgen kann.

Die elektrischen Anschlussgebiete bzw. Bondpads 11 sind voneinander isoliert und bestehen vorrangig aus Aluminium. Über die Bondpads 11 werden die elektrostatischen Kammelektroden 9, 10 des mikromechanischen Bauteils 100 elektrisch kontaktiert.

In dem in Fig. 13 gezeigten Ausführungsbeispiel wurde die Spiegelplatte 1 nach der Strukturierung des ersten und des zweiten Halbleitersubstrates 31, 32 mit der Reflexionsschicht 2 beschichtet. In anderen Ausführungsvarianten der Erfindung kann die Spiegelplatte 1 relativ zu Beginn der Technologie, nach dem Herstellen des Substratverbundes 33, vor einem ersten Trockenätzschritt zur Strukturierung des Substratverbundes 33 mit einer Reflexionsschicht 2 beschichtet werden.

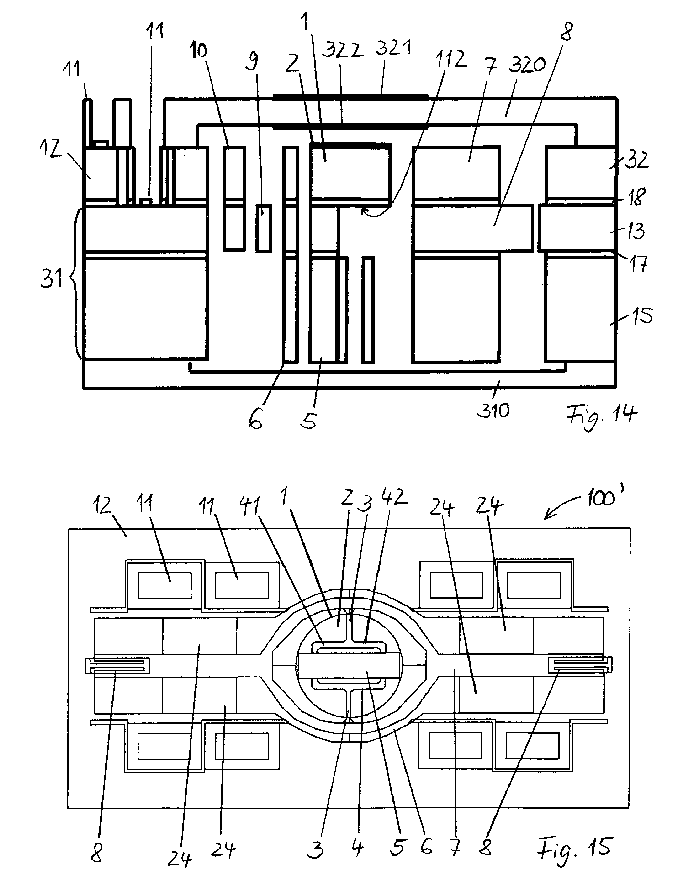

Fig. 14 zeigt schematisch eine spezielle Ausführungsvariante der vorliegenden Erfindung, in welcher die Struktur aus Fig. 13 mit einer oberen Abdeckung 320 und einer unteren Abdeckung 310 versehen wurde. Die obere Abdeckung ist eine optisch zumindest teilweise transparente Abdeckung 320, so dass elektromagnetische Strahlung durch die Abdeckung 320 auf die Spiegelplatte 1 auftreffen und von dieser abgelenkt werden kann.

An der Abdeckung 320 ist eine äußere Antireflexionsschicht 321 und eine innere Antireflexionsschicht 322 vorgesehen.

Das mit dem erfindungsgemäßen Verfahren hergestellte mikromechanische Bauteil 100 eignet sich insbesondere für eine Bilderzeugung durch Scannen von Laserlicht und für eine Bildaufnahme. Zur Bilderzeugung wird ein Strahlenbündel eines einfarbigen Lasers oder Laserlicht aus drei Laserquellen in den Farben Rot, Grün und Blau gleichzeitig von der Spiegelplatte 1 des mikromechanischen Bauteils 100 abgelenkt. Dabei erfolgt die Ablenkung vorzugsweise so, dass die Schwenkbewegung der höherfrequenten Achse bzw. der schnellen Scanachse horizontal orientierte Bildzeilen und die Schwenkbewegung der dazu orthogonal orientierten Achse bzw. der langsamen Scanachse eine viel langsamere und gleichförmige Ablenkung der Zeilen und eine schnelle Umkehr der Ablenkrichtung bewirkt, so dass eine Fläche zur Erzeugung eines Bildes auf einer Projektionsebene aufgespannt wird. Durch eine zur Schwenkbewegung synchrone Modulation der Intensität des Laserlichtes bzw. der Intensität dessen Rot-, Grün- und Blauanteils, wird die Bildinformation auf die Projektionsebene übertragen. Eine Bewegung um eine dritte Schwenkachse, die wiederum orthogonal zur Schwenkachse der hochfrequenten Bewegung angeordnet ist und durch die Kompensationsfeder 4 bewirkt wird, kompensiert die Verzerrung der Zeilen am linken bzw. rechten Bildrand.

Zur Bildaufnahme wird auf eine gleiche Art und Weise wie zur Bilderzeugung ein Laserstrahlbündel über die aufzunehmende Oberfläche der Spiegelplatte 1 geführt. Die Intensität des dabei je nach Oberflächeneigenschaften unterschiedlich reflektierten Lichtes wird mittels Fotodetektoren aufgenommen und zur Ablenkung synchron aufgezeichnet. Auf diese Weise erhält man eine Abbildung der Oberfläche im Wellenlängenbereich des verwendeten Laserlichtes.

Alternativ zur Aufnahme des reflektierten Laserlichtes ist die Detektion eventuell auftretender Lumineszenz bzw. Doppelphotonenlumineszenz durch entsprechend spektral sensitive Fotodetektoren möglich. Diese Art der Bildaufnahme ist besonders für miniaturisierte konfokale Mikroskopie und Endoskopie zur Analyse biologischer Materialien von Interesse.

Durch die Verwendung einer nahezu punktförmigen Lichtquelle zur Bilderzeugung bzw. Bildaufnahme wird eine starke Miniaturisierung der Geräte ermöglicht, da flächige Bilderzeuger wie LCD oder DLP bzw. flächige Detektoren wie CCD- oder CMOS-Bildsensoren durch diese Technologie abgelöst werden können.

Das exemplarisch für die vorliegende Erfindung in dem oben beschriebenen Figuren gezeigte mikromechanische Bauteil 100 stellt einen zweiachsigen mikromechanischen Scanner mit Kammantrieb dar, der mit Hilfe von Verfahren der Mikrosystemtechnologie herstellbar ist. Grundsätzlich kann bei einer anderen Ausführungsform des erfindungsgemäßen mikromechanischen Bauteils 100' auch anstelle der elektrostatischen Kammelektroden 9, 10 auch wenigstens ein piezoelektrisches Antriebselement 24 zur Ansteuerung der Kippbewegungen der Spiegelplatte 1 eingesetzt werden, wie es in Fig. 15 dargestellt ist. In dem gezeigten Ausführungsbeispiel sind die hier nur schematisch dargestellten Antriebselemente 24 strukturierte Membranen, die mit Piezoschichten versehen sind. Hinsichtlich der in Fig. 15 verwendeten Bezugszeichen und der damit gekennzeichneten Elemente des mikromechanischen Bauteils 100' wird auf die obigen Ausführungen verwiesen.

Die in den Figuren verwendeten Abmessungen der Strukturen sind nicht maßstabsgerecht wiedergegeben. Typischerweise liegen die geometrischen Abmessungen der mikromechanischen Bauteile 100, 100' in der Querschnittsdimension im Mikrometerbereich. Beispielsweise kann die Gesamtgröße des elektrostatischen zweiachsigen Scanners bei 10 mm liegen, wobei die Größe der Spiegelplatte 1 etwa 2 mm beträgt. In anderen Ausführungsvarianten der vorliegenden Erfindung können jedoch auch völlig andere Abmessungen verwendet werden.

## Patentansprüche

1. Mikromechanisches Bauteil (100, 100') zur Ablenkung elektromagnetischer Strahlung mit einem Bauteilrahmen (12), einer in mehreren Achsen kippbaren Spiegelplatte (1), einem um die Spiegelplatte (1) vorgesehenen und mit der Spiegelplatte (1) über wenigstens eine Horizontalfeder (3) und mit dem Bauteilrahmen (12) über wenigstens eine Vertikalfeder (8) gekoppelten Versteifungsrahmen (6); und elektrostatischen Kammelektroden (9, 10) oder wenigstens einem piezoelektrischen Antriebselement (24) zur Ansteuerung von Kippbewegungen der Spiegelplatte (1),
**dadurch gekennzeichnet,**
**dass** flächig an einer Rückseite (112) der Spiegelplatte (1) wenigstens ein Spiegelversteifungs- und Koppelelement (5) vorgesehen ist, das über die wenigstens eine Horizontalfeder (3) mit dem Versteifungsrahmen (6) gekoppelt ist, wobei die Horizontalfeder (3) teilweise von der Spiegelplatte (1) verdeckt ist.

2. Mikromechanisches Bauteil nach Anspruch 1, **dadurch gekennzeichnet, dass** zwischen dem wenigstens einen Spiegelversteifungs- und Koppelelement (5) und der wenigstens einen Horizontalfeder (3) wenigstens eine Kompensationsfeder (4) vorgesehen ist, wobei die Kompensationsfeder (4) so ausgebildet ist, dass eine Krafteinleitung von der wenigstens einen Horizontalfeder (3) in die Spiegelplatte (1) an wenigstens zwei verschiedenen Stellen des wenigstens einen Spiegelversteifungs- und Koppelelementes (5) möglich ist.

3. Mikromechanisches Bauteil nach Anspruch 2, **dadurch gekennzeichnet, dass** die Kompensationsfeder (4) Federarme aufweist, die eine Gabel ausbilden und an einem der Horizontalfeder (3) zugewandten Randbereich des Spiegelversteifungs- und Koppelelementes (5) ansetzen.

4. Mikromechanisches Bauteil nach Anspruch 2, **dadurch gekennzeichnet, dass** zwei Spiegelversteifungs- und Koppelelemente (5) auf der Rückseite (112) der Spiegelplatte (1) ausgebildet sind, zwischen welchen die Kompensationsfeder (4) derart angeordnet ist, dass jeder ihrer Federarme an einem der Spiegelversteifungs- und Koppelelemente (5) ansetzt.

5. Mikromechanisches Bauteil nach Anspruch 4, **dadurch gekennzeichnet, das** die Spiegelversteifungs- und Koppelelemente (5) etwa U-förmig oder rechteckförmig ausgebildet sind.

6. Mikromechanisches Bauteil nach einem der Ansprüche 2 bis 5, **dadurch gekennzeichnet, dass** das wenigstens eine Spiegelversteifungs- und Koppelelement (5), die wenigstens eine Kompensationsfeder (4) und ein überwiegender Teil der wenigstens einen Horizontalfeder (3) von der Spiegelplatte (1) verdeckt sind.

7. Mikromechanisches Bauteil nach einem der vorhergehenden Ansprüche, **dadurch gekennzeichnet, dass** die Spiegelplatte (1) etwa in Form einer Ellipse ausgebildet ist, deren Hauptachse in Richtung der wenigstens einen Vertikalfeder (8) liegt.

8. Mikromechanisches Bauteil nach einem der vorhergehenden Ansprüche, **dadurch gekennzeichnet, dass** die elektrostatischen Kammelektroden (9, 10) aus Rotorelektroden (9) und Statorelektroden (10) und ausgebildet sind, die eine Mehrzahl von Rotorzinken (25) und Statorzinken (26) aufweisen, wobei die freien Enden (27, 28) der Rotorzinken (25) und der Statorzinken (26) jeweils schmaler als deren feste Enden (29, 30) ausgebildet sind.

9. Mikromechanisches Bauteil nach einem der vorhergehenden Ansprüche, **dadurch gekennzeichnet, dass** die elektrostatischen Kammelektroden (9, 10) aus Rotorelektroden (9) und Statorelektroden (10) ausgebildet sind, die eine Mehrzahl von Rotorzinken (25) und Statorzinken (26) aufweisen, wobei die freien Enden (27) der Rotorzinken (25) eine von einer Geraden abweichende Berandungskurve (B) aufweisen.

10. Mikromechanisches Bauteil nach einem der vorhergehenden Ansprüche, **dadurch gekennzeichnet, dass** das wenigstens eine Spiegelversteifungs- und Koppelelement (5) so auf der Rückseite (112) der Spiegelplatte (1) ausgebildet ist, dass seine Ausdehnung in Richtung der wenigstens einen Vertikalfeder (8) größer als seine Ausdehnung in Richtung der wenigstens einen Horizontalfeder (3) ist.

11. Verfahren zum Herstellen eines mikromechanischen Bauteils (100) zur Ablenkung elektromagnetischer Strahlung, mit folgenden Schritten:
Bereitstellen eines ersten Halbleitersubstrates (31), das wenigstens eine erste Halbleiterebene (13) und eine zweite Halbleiterebene (15) aufweist, die von einer Isolatorschicht (17) voneinander getrennt sind, und eines zweiten Halbleitersubstrates (32);
Strukturieren der ersten Halbleiterebene (13) des ersten Halbleitersubstrates (31) unter Ausbildung eines oberen Teils (51) wenigstens eines Spiegelversteifungs- und Koppelelementes (5);
Bonden der strukturierten Seite des ersten Halbleitersubstrates (31) mit dem zweiten Halbleitersubstrat (32) unter Ausbildung eines Substratverbundes (33);
Strukturieren des zweiten Halbleitersubstrates (32) von der Vorderseite des Substratverbundes (33) unter Ausbildung einer Spiegelplatte (1), deren Rückseite (112) mit dem oberen Teil (51) des wenigstens einen Spiegelversteifungs- und Koppelelementes (5) verbunden ist, eines oberen Teils (61) eines um die Spiegelplatte (1) angeordneten Versteifungsrahmens (6) und eines oberen Teils (101) von Statorelektroden (10);
Strukturieren der ersten Halbleiterebene (13) des ersten Halbleitersubstrates (31) unter zumindest teilweiser Verwendung des zweiten Halbleitersubstrates (32) als Maskierung und unter Ausbildung eines mittleren Teils (62) des Versteifungsrahmens (6), wenigstens einer mit dem Versteifungsrahmen (6) über ein Tragwerk (7) gekoppelten Vertikalfeder (8), von Rotorelektroden (9) und eines unteren Teils (102) der Statorelektroden (10); und
Strukturieren der zweiten Halbleiterebene (15) des ersten Halbleitersubstrates (31) von der Rückseite des Substratverbundes (33) unter Ausbildung eines mit dem oberen Teil (51) des Spiegelversteifungs- und Koppelelementes (5) verbundenen unteren Teils (52) des Spiegelversteifungs- und Koppelelementes (5), eines unteren Teils (63) des Versteifungsrahmens (6) und wenigstens einer mit dem wenigstens einen Spiegelversteifungs- und Koppelelement (5) gekoppelten Horizontalfeder (3).

12. Verfahren nach Anspruch 11, **dadurch gekennzeichnet, dass** als erstes Halbleitersubstrat (31) ein SOI-Wafer verwendet wird.

13. Verfahren nach Anspruch 12, **dadurch gekennzeichnet, dass** der SOI-Wafer einen die zweite Halbleiterebene (15) ausbildenden Tragwafer mit einer Dicke von etwa 300 µm bis etwa 400 µm, eine die erste Halbleiterebene (13) ausbildende Decklage mit einer Dicke von etwa 30 µm bis etwa 100 µm und eine Isolatorschicht (17) mit einer Dicke von etwa 300 nm bis etwa 3 µm aufweist.

14. Verfahren nach einem der Ansprüche 11 bis 13, **dadurch gekennzeichnet, dass** als zweites Halbleitersubstrat (32) ein Siliziumwafer oder ein SOI-Wafer verwendet wird.

15. Verfahren nach einem der Ansprüche 11 bis 14, **dadurch gekennzeichnet, dass** das zweite Halbleitersubstrat (32) eine Dicke von etwa 50 µm bis etwa 150 µm aufweist oder nach dem Bonden mit dem ersten Halbleitersubstrat (31) auf eine Dicke von etwa 50 µm bis etwa 150 µm eingestellt wird.

16. Verfahren nach einem der Ansprüche 11 bis 15, **dadurch gekennzeichnet, dass** bei der Strukturierung der zweiten Halbleiterebene (15) des ersten Halbleitersubstrates (31) wenigstens eine Kompensationsfeder (4) zwischen der wenigstens einen Horizontalfeder (3) und dem wenigstens einen Spiegelversteifungs- und Koppelelement (5) ausgebildet wird.

17. Verfahren nach einem der Ansprüche 11 bis 16, **dadurch gekennzeichnet, dass** bei der Strukturierung des zweiten Halbleitersubstrates (32) zunächst senkrechte Vertiefungen (21) in das zweite Halbleitersubstrat (32) eingebracht werden, deren Boden etwa in der Hälfte der Dicke des zweiten Halbleitersubstrates (32) liegt, und daraufhin die verbliebenen Halbleiterbereiche (23) und mit einem Isolator (22) abgedeckte Bereiche des zweiten Halbleitersubstrates (32) als Maskierung für eine weitere Strukturierung des zweiten Halbleitersubstrates (32) verwendet werden.

18. Verfahren nach Anspruch 17, **dadurch gekennzeichnet, dass** das zweite Halbleitersubstrat (32) mit Hilfe eines zweistufigen fotolithografischen Prozesses strukturiert wird.

19. Verfahren nach einem der Ansprüche 11 bis 18, **dadurch gekennzeichnet, dass** die Spiegelplatte (1) nach der Strukturierung des ersten und des zweiten Halbleitersubstrates (31, 32) mit einer Reflexionsschicht (2) beschichtet wird.

20. Verfahren nach Anspruch 19, **dadurch gekennzeichnet, dass** die Beschichtung der Spiegelplatte (1) über eine Hartmaske erfolgt.

21. Verfahren nach einem der Ansprüche 11 bis 18, **dadurch gekennzeichnet, dass** die Spiegelplatte (1) vor einem ersten Trockenätzschritt zur Strukturierung des Substratverbundes (33) mit einer Reflexionsschicht (2) beschichtet wird.

22. Verfahren nach einem der Ansprüche 11 bis 21, **dadurch gekennzeichnet, dass** Bereiche der ersten Halbleiterebene (13) des ersten Halbleitersubstrates (31) und Bereiche des zweiten Halbleitersubstrates (32) mit elektrisch leitfähigen Bondpads (11) versehen werden.

23. Verfahren nach Anspruch 20 und 22, **dadurch gekennzeichnet, dass** die Beschichtung der Spiegelplatte (1) und die Ausbildung der Bondpads (11) über eine gemeinsame Hartmaske erfolgt.

24. Verfahren nach einem der Ansprüche 11 bis 23, **dadurch gekennzeichnet, dass** Vorder- und Rückseite des strukturierten Substratverbundes (33) mit jeweils einer Abdeckung (310, 320) versehen werden.

25. Verfahren nach Anspruch 24, **dadurch gekennzeichnet, dass** die Vorderseite des Substratverbundes (33) mit einer zumindest teilweise optisch transparenten Abdeckung (320) versehen wird.

## Geänderte Patentansprüche

### Geänderte Patentansprüche gemäss Regel 137(2) EPÜ.

**1.** Mikromechanisches Bauteil (100, 100') zur Ablenkung elektromagnetischer Strahlung mit
einem Bauteilrahmen (12),
einer in mehreren Achsen kippbaren Spiegelplatte (1),
einem um die Spiegelplatte (1) vorgesehenen und mit der Spiegelplatte (1) über wenigstens eine Horizontalfeder (3) und mit dem Bauteilrahmen (12) über wenigstens eine Vertikalfeder (8) gekoppelten Versteifungsrahmen (6); und
elektrostatischen Kammelektroden (9, 10) oder wenigstens einem piezoelektrischen Antriebselement (24) zur Ansteuerung von Kippbewegungen der Spiegelplatte (1),
**dadurch gekennzeichnet,**
**dass** flächig an einer Rückseite (112) der Spiegelplatte (1) wenigstens ein Spiegelversteifungs- und Koppelelement (5) vorgesehen ist, das über die wenigstens eine Horizontalfeder (3) mit dem Versteifungsrahmen (6) gekoppelt ist, wobei ein überwiegender Teil der Horizontalfeder (3) von der Spiegelplatte (1) verdeckt ist.

**2.** Mikromechanisches Bauteil nach Anspruch 1, **dadurch gekennzeichnet, dass** zwischen dem wenigstens einen Spiegelversteifungs- und Koppelelement (5) und der wenigstens einen Horizontalfeder (3) wenigstens eine Kompensationsfeder (4) vorgesehen ist, wobei die Kompensationsfeder (4) so ausgebildet ist, dass eine Krafteinleitung von der wenigstens einen Horizontalfeder (3) in die Spiegelplatte (1) an wenigstens zwei verschiedenen Stellen des wenigstens einen Spiegelversteifungs- und Koppelelementes (5) möglich ist.

**3.** Mikromechanisches Bauteil nach Anspruch 2, **dadurch gekennzeichnet, dass** die Kompensationsfeder (4) Federarme aufweist, die eine Gabel ausbilden und an einem der Horizontalfeder (3) zugewandten Randbereich des Spiegelversteifungs- und Koppelelementes (5) ansetzen.

**4.** Mikromechanisches Bauteil nach Anspruch 2, **dadurch gekennzeichnet, dass** zwei Spiegelversteifungs- und Koppelelemente (5) auf der Rückseite (112) der Spiegelplatte (1) ausgebildet sind, zwischen welchen die Kompensationsfeder (4) derart angeordnet ist, dass jeder ihrer Federarme an einem der Spiegelversteifungs- und Koppelelemente (5) ansetzt.

**5.** Mikromechanisches Bauteil nach Anspruch 4, **dadurch gekennzeichnet**, das die Spiegelversteifungs- und Koppelelemente (5) etwa U-förmig oder rechteckförmig ausgebildet sind.

**6.** Mikromechanisches Bauteil nach einem der Ansprüche 2 bis 5, **dadurch gekennzeichnet, dass** das wenigstens eine Spiegelversteifungs- und Koppelelement (5) und die wenigstens eine Kompensationsfeder (4) von der Spiegelplatte (1) verdeckt sind.

**7.** Mikromechanisches Bauteil nach einem der vorhergehenden Ansprüche, **dadurch gekennzeichnet, dass** die Spiegelplatte (1) etwa in Form einer Ellipse ausgebildet ist, deren Hauptachse in Richtung der wenigstens einen Vertikalfeder (8) liegt.

**8.** Mikromechanisches Bauteil nach einem der vorhergehenden Ansprüche, **dadurch gekennzeichnet, dass** die elektrostatischen Kammelektroden (9, 10) aus Rotorelektroden (9) und Statorelektroden (10) und ausgebildet sind, die eine Mehrzahl von Rotorzinken (25) und Statorzinken (26) aufweisen, wobei die freien Enden (27, 28) der Rotorzinken (25) und der Statorzinken (26) jeweils schmaler als deren feste Enden (29, 30) ausgebildet sind.

**9.** Mikromechanisches Bauteil nach einem der vorhergehenden Ansprüche, **dadurch gekennzeichnet, dass** die elektrostatischen Kammelektroden (9, 10) aus Rotorelektroden (9) und Statorelektroden (10) ausgebildet sind, die eine Mehrzahl von Rotorzinken (25) und Statorzinken (26) aufweisen, wobei die freien Enden (27) der Rotorzinken (25) eine von einer Geraden abweichende Berandungskurve (B) aufweisen.

**10.** Mikromechanisches Bauteil nach einem der vorhergehenden Ansprüche, **dadurch gekennzeichnet, dass** das wenigstens eine Spiegelversteifungs- und Koppelelement (5) so auf der Rückseite (112) der Spiegelplatte (1) ausgebildet ist, dass seine Ausdehnung in Richtung der wenigstens einen Vertikalfeder (8) größer als seine Ausdehnung in Richtung der wenigstens einen Horizontalfeder (3) ist.
